(19) Europäisches Patentamt
European Patent Office
Office européen des brevets

(11) **EP 4 765 650 A1**

(12) **DEMANDE DE BREVET EUROPEEN**

(43) Date de publication:
**24.06.2026 Bulletin 2026/26**

(21) Numéro de dépôt: **25224642.6**

(22) Date de dépôt: **17.12.2025**

(51) Classification Internationale des Brevets (IPC):
**H03M 13/27** (2006.01)   **H04L 1/06** (2006.01)

(52) Classification Coopérative des Brevets (CPC):
**H03M 13/27; H03M 13/2782; H03M 13/6561;**
H03M 13/25; H04L 1/0041; H04L 1/0071

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **18.12.2024 FR 2414474**

(71) Demandeur: **THALES**
**92190 Meudon (FR)**

(72) Inventeurs:
• **THAO, Som-Sai**
**92622 GENNEVILLIERS CEDEX (FR)**
• **EUDES, Jacques**
**92622 GENNEVILLIERS CEDEX (FR)**
• **MOREAU, Olivier**
**92622 GENNEVILLIERS CEDEX (FR)**

(74) Mandataire: **Lavoix**
**2, place d'Estienne d'Orves**
**75441 Paris Cedex 09 (FR)**

(54) **DISPOSITIF, ET PROCEDE, D ENTRELACEMENT**

(57) L'invention concerne un procédé d'entrelacement de données avec $n_{core}$ cœur(s) de processeur associés chacun à une mémoire locale dont la partie dédiée à la sortie de l'entrelacement est de taille strictement inférieure à la longueur d'entrelacement L, comprenant :

mise en œuvre, N fois, de l'algorithme d'entrelacement de longueur L sur ladite séquence d'entrée, la séquence d'entrée entrelacée étant la réunion de sous-séquences S_1, ..., S_N ;

la $i^{ème}$ mise en œuvre, i = 1 à N, de l'entrelacement étant réalisée par un des $n_{core}$ cœurs, puis stockage dans ladite partie de mémoire locale dudit cœur de seulement S_i ;

transfert de S_i dans une mémoire externe au cœur de processeur.

FIG.5

EP 4 765 650 A1

## Description

**Domaine** technique :

L'invention se situe dans le domaine de l'informatique et des télécommunications et concerne plus particulièrement les modules de type entrelaceurs et désentrelaceurs.

Ces modules sont principalement utilisés dans la communication de données, les fichiers multimédias, dans les transmissions radio (par exemple, satellite ou TV numérique ou ADSL). Historiquement, ils sont également utilisés pour le stockage des données triées sur disque dur ou encore dans les supports optiques (CD-ROM, DVD, etc.) pour protéger les données des rayures et des dommages au support de stockage.

**Technique** antérieure :

Un entrelaceur est adapté pour effectuer un entrelacement, i.e. traiter un signal numérique pour réorganiser des données, qui y sont contiguës, sous une forme non contiguë. Notamment dans la couche physique d'un modem radio, un entrelaceur est mis en œuvre pour séparer les bits consécutifs à transmettre, le plus loin possible sur la longueur de l'entrelaceur. Il en résulte que les bits à transmettre, qui étaient à l'origine consécutifs, sont espacés.

Un entrelacement a pour effet d'améliorer les performances, par exemple en termes de détection et correction d'erreurs, dans le traitement ultérieur du signal, par exemple suite à une transmission affectée de paquets d'erreurs consécutives. On cherche ainsi à uniformiser les erreurs bits à la réception, pour ne pas avoir de résonance du décodeur d'erreur. Une méthode classique consiste à construire un tableau rectangulaire dans lequel chaque ligne représente un vecteur de bits émis. Le tableau est ensuite lu par colonne. Plus des bits consécutifs se retrouvent espacés, meilleure sera la résistance du signal aux perturbations.

L'opération inverse est appelée désentrelacement et est effectuée dans un désentrelaceur et a pour but de reconstituer l'ordre d'origine des données. Le désentrelacement est donc aussi un entrelacement.

Plus grande est la longueur de l'entrelaceur, meilleure est la performance du modem en termes de Taux d'Erreur Binaire (TEB).

La longueur de l'entrelaceur (ou longueur d'entrelacement) est la quantité d'informations qui participent à une exécution de l'opération d'entrelacement. Cette quantité correspond au nombre de données en entrée et en sortie du traitement d'entrelacement.

Quand l'entrelaceur est implémenté (embarqué) sur un processeur de signal numérique, appelé encore DSP (de l'anglais « Digital Signal Processor ») d'un modem radio opérant en temps réel, la longueur de l'entrelaceur peut être limitée par la taille de la mémoire locale d'un cœur du DSP. Si une mémoire externe est associée au DSP, celle-ci peut être utilisée, mais le temps d'accès aux données est plus long.

La mémoire locale d'un cœur de DSP est plutôt petite alors qu'il serait préférable pour un entrelaceur qu'elle soit plus grande.

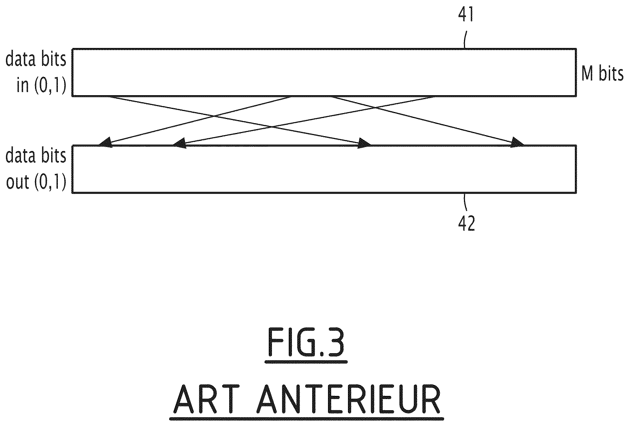

La figure 3 illustre schématiquement le principe de fonctionnement d'un entrelaceur dans l'art antérieur : les positions des bits consécutifs d'une séquence 41 de M bits consécutifs fournie en entrée de l'entrelaceur sont redéfinies par la mise en œuvre, dans un cœur de DSP, d'un algorithme d'entrelacement et se retrouvent organisés, en sortie de l'entrelaceur, selon une séquence 42, dans un ordre différent, dans la mémoire locale du cœur de DSP. Cette mémoire locale de taille supérieure ou égale à 2xM bits (comportant les M bits de la séquence 41 en entrée et les M bits de la séquence 42 en sortie) ; dans l'exemple considéré la taille de la mémoire locale est de 130 ko (kilo octets), ce qui limite la longueur d'entrelacement L (= M).

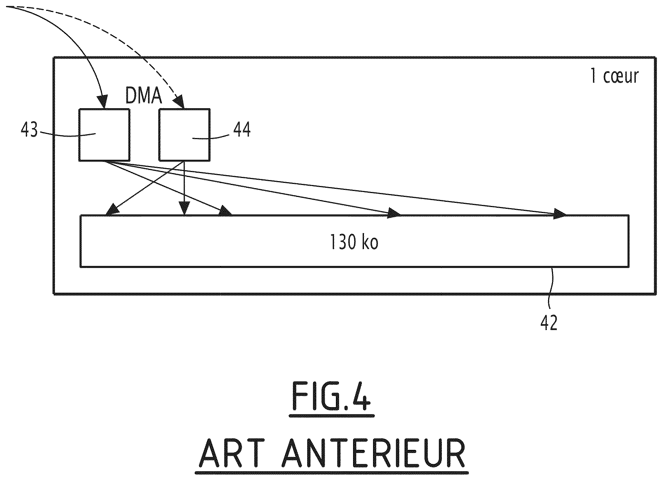

La figure 4 illustre un art antérieur dans lequel, par rapport à l'exemple de la figure 3, un ou des registres, ici deux registres DMA 43 et 44, dans l'entrelaceur implémenté sur un cœur de DSP, extraient successivement les bits d'une séquence à entrelacer qui est stockée dans une mémoire externe au DSP.

Il existe donc un besoin d'améliorer les performances des dispositifs comprenant un entrelaceur.

**Résumé de l'invention** :

À cet effet, suivant un premier aspect, la présente invention décrit un procédé d'entrelacement comprenant un ensemble de $n_{core}$ cœur(s) de processeur, chaque cœur étant associé à une mémoire locale de processeur dont la partie dédiée à la sortie de l'entrelacement est de taille T strictement inférieure à la longueur d'entrelacement L et étant adapté pour mettre en œuvre un algorithme d'entrelacement de longueur L, et $n_{core}$ étant un entier supérieur ou égal à 1, ledit dispositif étant adapté pour mettre en œuvre les étapes suivantes pour réaliser un entrelacement sur une séquence de données à entrelacer :

- mise en œuvre, N fois, de l'algorithme d'entrelacement de longueur L sur au moins une partie respective de ladite séquence d'entrée, la séquence d'entrée entrelacée étant égale à la réunion de plusieurs sous-séquences consécutives distinctes S_1, ..., S_N et N >1 ;

- la $i^{ème}$ mise en œuvre, i = 1 à N, de l'entrelacement sur au moins une partie de ladite séquence d'entrée étant réalisée par un cœur de l'ensemble des $n_{core}$ cœurs, ladite mise en œuvre étant suivie du stockage dans ladite partie de mémoire locale dudit cœur de, parmi les sous-séquences S_1, ..., S_N, seulement la sous-séquence S_i ;

- puis transfert de chaque sous-séquence S_i dans une mémoire prédéfinie, externe au cœur de processeur ; à l'issue des N transferts, ladite mémoire externe comportant ainsi la séquence d'entrée entrelacée.

L'invention permet donc d'obtenir un résultat en sortie de l'entrelaceur qui est plus long que la partie de la mémoire locale d'un cœur d'un DSP qui était disponible dans l'art antérieur pour accueillir le résultat de l'entrelacement.

Dans des modes de réalisation, un tel procédé comprendra en outre l'une au moins des caractéristiques suivantes :

- $n_{core}$ = N, et la $i^{ème}$ mise en œuvre, i = 1 à N, de l'entrelacement est réalisée par le $i^{ème}$ cœur de processeur, i = 1 à N ;

- $n_{core}$ < N et au moins un même cœur parmi les $n_{core}$ cœurs effectue successivement :

  - la $i^{ème}$ mise en œuvre, i compris entre 1 et N-1, de l'entrelacement sur au moins une partie de ladite séquence d'entrée suivie du stockage dans la mémoire locale dudit cœur de seulement la sous-séquence S_i, puis du transfert de la sous-séquence S_i dans la mémoire externe prédéfinie ;

  - la $j^{ème}$ mise en œuvre, j compris entre 2 et N et strictement supérieur à i, de l'entrelacement sur au moins une partie de ladite séquence d'entrée suivie du stockage dans la mémoire locale dudit cœur de seulement la sous-séquence S_j, puis du transfert de la sous-séquence S_j dans la mémoire externe prédéfinie ;

- l'indice des bits d'entrée qui sont dans la sous-séquence S_i est précalculé, ainsi que leurs positions respectives associées dans la sous-séquence S_i, et la $i^{ème}$ mise en œuvre, i = 1 à N, de l'entrelacement sur au moins une partie de ladite séquence d'entrée réalisée par un cœur est effectuée en fonction de l'indice précalculé des bits d'entrée dans la sous-séquence S_i et leurs positions respectives associées dans la sous-séquence S_i.

Suivant un autre aspect, l'invention décrit un dispositif d'entrelacement comprenant un ensemble de $n_{core}$ cœur(s) de processeur, chaque cœur étant associé à une mémoire locale de processeur dont la partie dédiée à la sortie de l'entrelacement est de taille T strictement inférieure à la longueur d'entrelacement L, ledit dispositif d'entrelacement étant adapté pour mettre en œuvre un algorithme d'entrelacement de longueur L, et $n_{core}$ étant un entier supérieur ou égal à 1, ledit dispositif étant adapté pour mettre en œuvre N fois l'algorithme d'entrelacement de longueur L sur au moins une partie respective d'une séquence d'entrée de données à entrelacer, la séquence d'entrée entrelacée étant égale à la réunion de plusieurs sous-séquences consécutives distinctes S_1, ..., S_N et N > 1 ;

dans lequel la $i^{ème}$ mise en œuvre, i = 1 à N, de l'entrelacement sur au moins une partie de ladite séquence d'entrée est réalisée par un cœur de l'ensemble des $n_{core}$ cœurs, ledit dispositif étant adapté pour, à la suite de ladite mise en œuvre, stocker dans ladite partie de mémoire locale dudit cœur de, parmi les sous-séquences S_1, ..., S_N, seulement la sous-séquence S_i ;

ledit dispositif étant adapté pour transférer ensuite chaque sous-séquence S_i dans une mémoire prédéfinie, externe au cœur de processeur de manière à ce qu'à l'issue des N transferts, ladite mémoire externe comportant ainsi la séquence d'entrée entrelacée.

Dans des modes de réalisation, un tel dispositif comprendra en outre l'une au moins des caractéristiques suivantes :

- $n_{core}$ = N, et dans lequel la $i^{ème}$ mise en œuvre, i = 1 à N, de l'entrelacement est réalisée par le $i^{ème}$ cœur de processeur, i = 1 à N ;

- $n_{core}$ < N et au moins un même cœur parmi les $n_{core}$ cœurs est adapté pour effectuer successivement :

  - la $i^{ème}$ mise en œuvre, i compris entre 1 et N-1, de l'entrelacement sur au moins une partie de ladite séquence d'entrée suivie du stockage dans la mémoire locale dudit cœur de seulement la sous-séquence S_i, puis du transfert de la sous-séquence S_i dans la mémoire externe prédéfinie ;

  - la $j^{ème}$ mise en œuvre, j compris entre 2 et N et strictement supérieur à i, de l'entrelacement sur au moins une partie de ladite séquence d'entrée suivie du stockage dans la mémoire locale dudit cœur de seulement la sous-séquence S_j, puis du transfert de la sous-séquence S_j dans la mémoire externe prédéfinie ;

- l'indice des bits d'entrée qui sont dans la sous-séquence S_i est précalculé, ainsi que leurs positions respectives associées dans la sous-séquence S_i, et le dispositif est adapté pour effectuer la $i^{ème}$ mise en œuvre, i = 1 à N, de l'entrelacement sur au moins une partie de ladite séquence d'entrée réalisée par un cœur en fonction de l'indice précalculé des bits d'entrée dans la sous-séquence S_i et leurs positions respectives associées dans la sous-séquence S_i.

Suivant un autre aspect, l'invention décrit un programme d'ordinateur destiné à être stocké dans la mémoire, d'un dispositif d'entrelacement comprenant un DSP comportant un ensemble de $n_{core}$ cœur(s) de processeur, chaque cœur étant associé à une mémoire locale de processeur dont la partie (42) dédiée à la sortie de l'entrelacement est de taille T strictement inférieure à la longueur d'entrelacement L et étant adapté pour mettre en œuvre un algorithme d'entrelacement de longueur L, et $n_{core}$ étant un entier supérieur ou égale à 1, ledit dispositif d'entrelacement comprenant un microcalculateur, ledit programme d'ordinateur comprenant des instructions qui, lorsqu'elles sont exécutées sur le microcalculateur, mettent en œuvre les étapes d'un procédé selon l'invention.

L'invention décrit également un support non transitoire lisible par ordinateur stockant un tel programme informatique.

**Brève description des figures** :

L'invention sera mieux comprise et d'autres caractéristiques, détails et avantages apparaîtront mieux à la lecture de la description qui suit, donnée à titre non limitatif, et grâce aux figures annexées, données à titre d'exemple.

[Fig. 1] La figure 1 est un schéma d'un système de radiocommunication dans un mode de réalisation de l'invention ;

[Fig. 2] La figure 2 représente les étapes d'un procédé d'entrelacement dans un mode de réalisation de l'invention ;

[Fig. 3] La figure 3 illustre schématiquement le principe de fonctionnement d'un entrelaceur de l'art antérieur ;

[Fig. 4] La figure 4 illustre schématiquement le principe de fonctionnement d'un entrelaceur de l'art antérieur ;

[Fig. 5] La figure 5 est illustre schématiquement le principe de fonctionnement d'un entrelaceur dans un mode de réalisation de l'invention ;

[Fig. 6] La figure 6 est un comparatif de caractéristiques d'entrelacements ;

[Fig. 7] La figure 7 illustre schématiquement le fonctionnement d'un procédé dans un mode de réalisation de l'invention utilisant 4 cœurs d'un DSP.

Des références identiques peuvent être utilisées dans des figures différentes lorsqu'elles désignent des éléments identiques ou comparables.

**Description détaillée** :

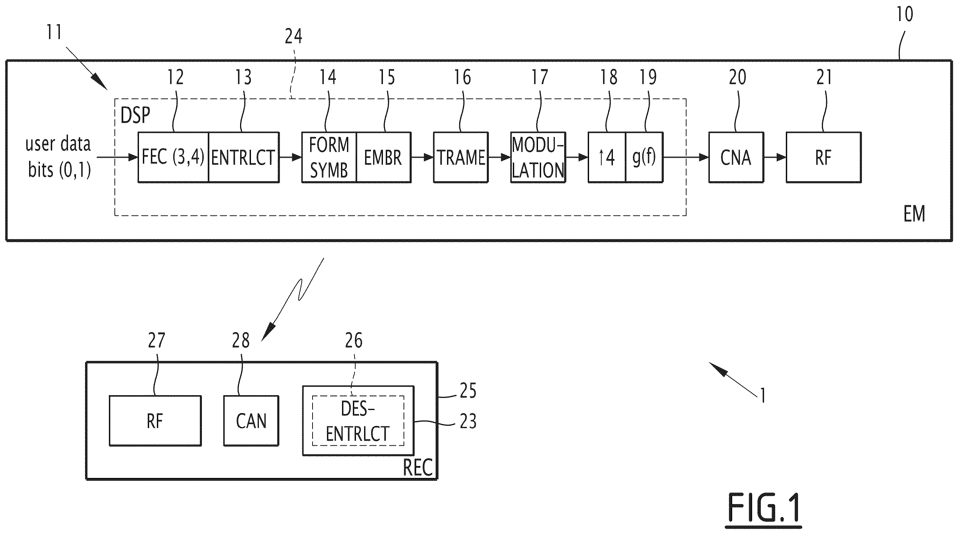

Un système de radiocommunication 1 dans un mode de réalisation de l'invention est représenté schématiquement sur la figure 1. Il comporte un dispositif émetteur de radiocommunication 10, nommé EM 10, et un dispositif récepteur de radiocommunication 25, nommé REC 25, adaptés pour communiquer l'un avec l'autre.

Bien entendu, dans un mode de réalisation, le dispositif 10 (similairement le dispositif 25), est adapté pour fonctionner en émetteur et en récepteur et comporte, en outre, dans ce cas un module similaire au dispositif récepteur 25 pour la réception.

Le dispositif EM 10 comprend un modem radio 11 adapté pour recevoir des données binaires à transmettre, pour les traiter et les mettre en forme, notamment en entrelaçant les données à l'aide d'un entrelaceur, puis les moduler. Le dispositif EM 10 est adapté pour, après traitement par un convertisseur numérique-analogique 20 et un étage radiofréquence 21, transmettre le signal radiofréquence résultant sur un ou des canaux radiofréquences (RF) via une antenne RF.

Symétriquement le dispositif REC 25 est adapté pour recevoir un signal radiofréquence transmis par EM 10. Le dispositif REC 25 comprend notamment un étage de réception radiofréquence 27, un convertisseur analogique-numérique (CAN) 28 et un modem 23 adapté pour démoduler le signal radiofréquence reçu une fois numérisé, pour extraire des données binaires du signal en sortie de CAN 28 et les traiter y compris les désentrelacer à l'aide d'un désentrelaceur 26.

La partie relative au modem 11 du dispositif EM 10 est plus particulièrement représentée sur la figure 1. Le modem 11 comprend, par exemple dans le cas présent, comme il est connu, un bloc FEC 12 (FEC acronyme de l'expression anglaise Forward Error Correction), un bloc entrelaceur 13, un bloc de formation de symboles 14, un bloc d'embrouillage 15, un bloc de mise en trame 16, un bloc de modulation 17, un suréchantillonneur 18 et un filtre de mise en forme (par exemple de type demi-Nyquist) 19.

Les blocs 12 à 19 (ou au moins certains de ces blocs) sont par exemple implémentés sur un processeur de signal numérique 24, nommé DSP 24.

Dans un mode de réalisation, une partie au moins des blocs du modem 11, dont l'entrelaceur 13, sont des blocs de traitements des données numériques. Typiquement, les fonctions de l'entrelaceur 13 (ou au moins une partie de ces fonctions) sont mises en œuvre via l'exécution, sur le DSP 24, d'instructions logicielles stockées dans une mémoire du dispositif EM 10 (la mémoire locale du DSP 24 par exemple).

Le DSP 24 comporte $n_{core}$ cœur(s) de processeur associé(s) chacun à une mémoire locale respective, avec $n_{core}$ égal à 1 ou strictement supérieur à 1. Une partie, nommée 42_k, de taille T, de la mémoire locale respectivement associée au $k^{ème}$ cœur (k = 1 à $n_{core}$) est dédiée à la sortie de l'entrelaceur 13.

On entend par mémoire locale d'un cœur de processeur la mémoire associée à (la plus proche de) chaque cœur accessible directement depuis le CPU (en anglais « Central Processing Unit ») du cœur par un bus local, c'est celle qui permet au CPU l'accès le plus rapide à des données. Les autres mémoires accessibles par le cœur le sont de manière indirecte par l'intermédiaire d'un transfert DMA (en anglais « Direct Memory Access ») vers (depuis) la mémoire locale ou par un système de cache qui réside en mémoire locale.

La longueur d'entrelacement, L, est strictement supérieure à T (i.e. la taille de la partie 42_k de la mémoire locale du $k^{ème}$ cœur (k = 1 à $n_{core}$) est insuffisante pour contenir les données de la séquence d'entrée une fois ces dernières entrelacées par l'algorithme d'entrelacement de longueur d'entrelacement L). L est par exemple supérieure à (N-1)xT et inférieure ou égale à NxT, avec N entier strictement supérieur à 1. Dans le cas considéré L est par exemple égale à NxT.

Dans un mode de réalisation, la taille de la mémoire locale d'un cœur est ainsi égale à la somme de la taille des 2 registres DMA, de T, de la taille du programme logiciel et de la taille du cache (Data, Programme).

La solution technique proposée selon l'invention permet de compenser la faible taille de la mémoire locale d'un cœur d'un DSP multicore.

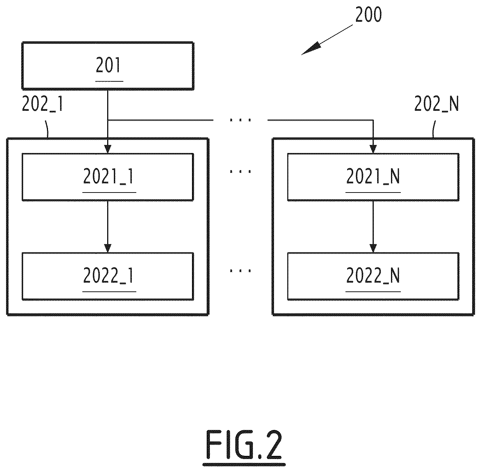

L'entrelaceur 13 est adapté pour mettre en œuvre un procédé d'entrelacement dans un mode de mise en œuvre de l'invention, comportant l'ensemble d'étapes 200 représenté en figure 2.

Dans une étape 201, l'entrelaceur 13 obtient en entrée une séquence de données binaires à entrelacer (dans le cas considéré, issue du bloc FEC 12).

Il réalise ensuite les étapes 202_i, i = 1 à N, mettant ainsi en œuvre N fois (avec N entier strictement supérieur à 1) le même algorithme d'entrelacement sur l'intégralité de cette même séquence d'entrée.

Chaque étape 202_i comporte une sous-étape 2021_i, suivie d'une sous-étape 2022_i.

Dans l'étape 2021_i, un cœur de processeur du DSP 24, par exemple le $k^{ème}$ cœur, obtient en entrée la séquence de données binaires à entrelacer, puis met en œuvre l'algorithme d'entrelacement de taille L, ici L = NxT, ce qui génère comme résultat une séquence occupant une longueur de taille L, composée des sous-séquences successives S_1, S_2, ..., S_N, chacune de taille T.

La taille de la séquence de données à entrelacer fournie en entrée de l'entrelaceur est L et L = NxT est la taille du résultat d'entrelacement.

Dans l'étape 2022_i, à l'issue du calcul d'entrelacement de l'étape 2021_i, seule la sous-séquence S_i est mémorisée dans la partie 42_k de la mémoire locale du $k^{ème}$ cœur de processeur utilisé à l'étape 2021_i. Puis cette sous-séquence S_i est extraite depuis cette partie de la mémoire locale et est fournie à une mémoire externe (par exemple celle dont provient la séquence d'entrée fournie à l'étape 201) au cœur de processeur (et externe au DSP 24), de taille supérieure à NT, dans laquelle l'ensemble des sous-séquences S_i, i = 1 à N, seront stockées in fine, de manière consécutive reconstituant ainsi la séquence d'entrée dans sa forme entrelacée, avec la longueur d'entrelacement L.

Ensuite, les traitements correspondant aux blocs 14 à 21 sont réalisés sur cette séquence entrelacée, le signal correspondant étant ensuite émis à destination du récepteur 25.

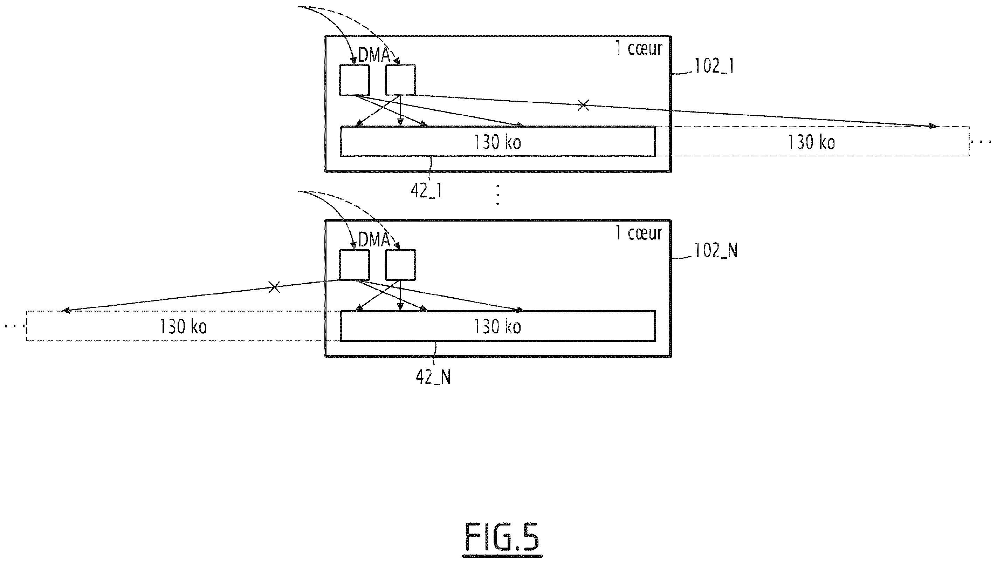

Dans l'exemple particulier considéré maintenant, le DSP 24 comporte $n_{core}$ = N cœurs de processeur référencés 102_1, ..., 102_N, comme représenté en figure 5.

À chaque cœur de processeur 102_i, i = 1 à N, est associée la partie 42_i, de la mémoire locale ; cette partie est de taille T ; ici T est égale à 130 ko.

Dans le cas considéré, pour i = 1 à N, l'étape 202_i est mise en œuvre par le cœur de processeur 102_i. Par exemple, elle se déroule en parallèle de l'étape 202_j mise en œuvre dans le cœur de processeur 102_j, avec i, j distincts et prenant une valeur quelconque de 1 à N. Cela permet de satisfaire des contraintes de performances de traitement de l'entrelaceur en temps réel.

Chaque cœur de processeur 102_i calcule l'intégralité du résultat ; mais seule la sous-séquence S_i est mémorisée dans la mémoire locale 42_i (le reste des sous-séquences, représenté en pointillés, n'est lui pas sauvegardé dans la mémoire locale 42_i dans l'étape 202_i).

Dans un tel cas d'implémentation sur N processeurs (cœurs) d'un DSP multicore :

- chaque cœur de processeur lit l'intégralité de la séquence d'entrée (soit RX = 1),

- chaque cœur de processeur traite (calcule l'entrelacement de) l'intégralité de la séquence d'entrée et ne sauvegarde en mémoire locale qu'une partie sur N de la sortie de l'entrelaceur (sélectivement la sous-séquence S_i),

- les données de sortie (la sous-séquence S_i) d'un processeur restent locales avant d'être transférées en bloc dans la mémoire externe (DRAM, de l'anglais « Dynamic Random Access Memory ») à la fin du traitement de l'intégralité de la séquence d'entrée d'un processeur (soit TX = 1 pour l'ensemble des sous-séquences S_i).

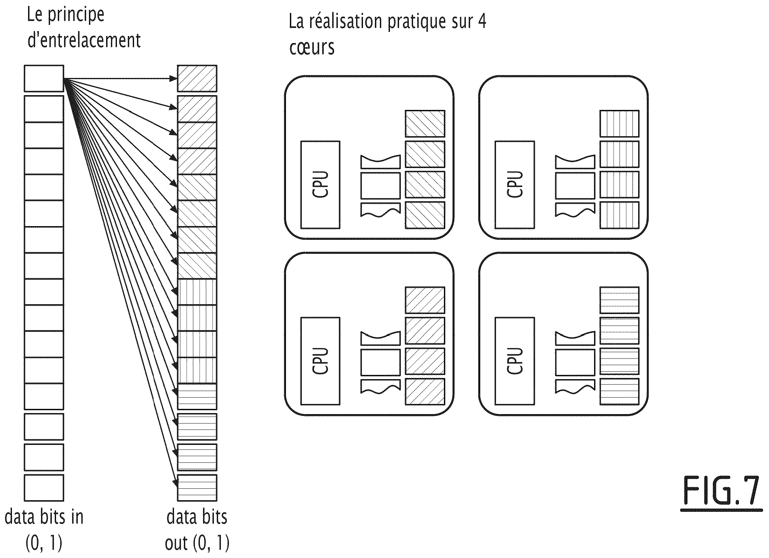

Pour N = 4, correspondant à l'illustration schématique en figure 7 :

- le coût CPU est multiplié par 4 ;

- la bande passante = débit nécessaire (bits/sec) pour les informations échangées entre les cœurs et la mémoire externe est multipliée par 2,5 : elle passe de (RX = 1) + (TX = 1) à (RX = 4) + (TX = 1).

Dans un autre mode de réalisation, les N étapes 202_1 à 202_N sont réalisées par un entrelaceur mis en œuvre avec un nombre $n_{core}$ de processeurs strictement inférieur à N. Au moins un même cœur de processeur est alors utilisé pour réaliser en série plusieurs étapes 202_i parmi les N étapes 202_i, i = 1 à N. Une telle mise en œuvre de l'invention est satisfaisante si les contraintes temporelles de l'application utilisant cet entrelacement le permettent. Par exemple, $n_{core}$ = 1 et les N étapes 202_1 à 202_N sont alors réalisées en série par le seul cœur de processeur. Ou encore si $n_{core}$ = N/2, chaque cœur de processeur réalise 2 étapes 202_i sur les N.

Dans un mode de réalisation, à la première passe, à la première séquence d'entrée traitée par l'entrelaceur, chaque cœur de processeur sauvegarde un tableau d'information (e.g. 0 ou 1) indiquant si le résultat de l'entrelaceur (pour chaque bit d'entrée) est à conserver ou pas dans sa mémoire locale lors d'une étape 202_i dont il est en charge. Cela consomme plus de temps la première fois, mais au prix d'un gain pour les séquences d'entrée suivantes, en utilisant ce tableau de calculs intermédiaires (pour la mise en œuvre les séquences d'entrée suivantes de l'étape 202_i dont il est en charge) et la mémoire cache (dans la mémoire locale) du processeur. La position doit toujours être recalculée et un test doit être effectué. Lors du test, soit il est vérifié comment se situe la position par rapport à l'intervalle à traiter (i.e. la sous-séquence S_i à conserver), soit une information binaire est lue qui indique si la position doit être stockée.

Dans un mode de réalisation, chaque cœur de processeur n° k, k = 1 à $n_{core}$, pré-calcule l'indice des bits d'entrée qui sont à sauvegarder dans sa mémoire locale et les positions associées (sous-séquence S_i). Au prix d'un pré-calcul, des économies importantes de calcul sont réalisées car on ne calcule plus ensuite toutes les positions pour n'en utiliser seulement qu'une partie (seule la partie pertinente est calculée). Le pré-calcul est intéressant pour un modem où il n'y a pas d'aléas modifiant les paramètres de l'entrelaceur à prendre en compte à chaque nouvelle séquence d'entrée.

La solution technique proposée consiste ainsi à réaliser N fois la fonction d'entrelacement en émission (respectivement désentrelacement en réception) et sauvegarder à chaque fois uniquement une sous-séquence (sur N) du résultat (les sous-séquence s à chaque fois étant distinctes, voire disjointes, par exemple consécutives) : CPU x ~N (dans les deux derniers modes de réalisation décrits ci-dessus) ; Bande Passante (BP) x -N.

Au final, on obtient le résultat (complet) avec une longueur d'entrelacement de N fois la longueur d'entrelacement conventionnelle (i.e. sur un seul cœur). Les calculs de l'algorithme d'entrelacement sont dupliqués N fois (et donc indépendants) : davantage d'opérations (plus de calculs et d'accès mémoire en lecture) que nécessaires sont donc réalisés (les calculs de (N-1) sous-séquences S_i sont avortés) ; c'est le prix à payer pour obtenir une solution au problème technique matériel de compenser la faible taille de la mémoire locale d'un cœur d'un DSP i.e. d'augmenter la longueur d'entrelacement.

Les données unitaires à entrelacer entre elles sont suivant les modes de réalisation de l'invention, des bits ou alors des bits pondérés (par exemple quantifiés sur 8 bits).

L'invention peut bien sûr être mise en œuvre avec des longueurs d'entrelacement variables et elle comporte un intérêt dès lors que la longueur d'entrelacement est strictement supérieure à la taille T de la partie 42 de la mémoire locale d'un cœur dédié à l'entrelaceur.

L'invention peut être mise en œuvre avec des mémoires locales de cœur ayant des tailles non égales entre elles.

Un dispositif, respectivement un procédé selon l'invention permet ainsi d'augmenter la longueur conventionnelle de l'entrelaceur utilisé.

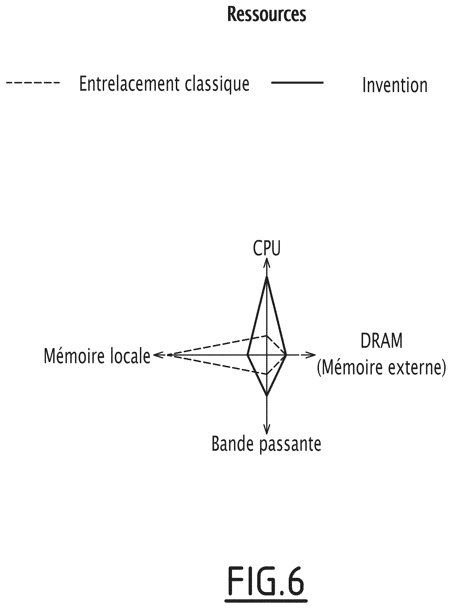

La figure 6 représente l'utilisation comparée des ressources CPU, Bande Passante, mémoire locale d'un processeur et mémoire externe pour les méthodes d'entrelacement respectivement classique (par exemple de type modem HF STANAG 4539® sur un cœur) et enfin selon l'invention.

L'invention peut être mise en œuvre dans diverses applications encore telles que : LDPC, codeur convolutif, cryptologie.

Il a été décrit ci-dessus l'invention mise en œuvre relativement à un entrelaceur. Bien sûr, l'invention s'applique similairement relativement à un désentrelaceur (typiquement celui du dispositif récepteur 25, qui est en fait lui aussi un entrelaceur mais appliquant un algorithme d'entrelacement inverse de celui qui a été effectué sur les données fournies à l'entrée de l'entrelaceur

Le procédé décrit peut-être mis en œuvre par l'exécution d'instructions logicielles sur un processeur. Alternativement, il peut être mis en œuvre par un hardware dédié, typiquement un circuit intégré numérique, soit spécifique (ASIC/ Application-Specific Integrated Circuit) ou basé sur une logique programmable (par exemple FPGA/Field Programmable Gate Array).

Selon un mode de réalisation, le procédé est mis en œuvre sur un accélérateur matériel, de l'anglais *hardware accelerator.*

Notamment, lors de la mise en œuvre du procédé, au moins un cœur, réalise un déport - de l'anglais *offloading* - de tout ou partie de ses calculs vers un accélérateur matériel respectif. Par exemple, chaque cœur réalise ledit déport vers un accélérateur matériel respectif.

Par exemple, chaque cœur réalise ledit déport vers le même accélérateur matériel.

La taille T de la partie 42 de la mémoire est avantageusement strictement inférieure à la taille de la mémoire locale.

Préférentiellement, la longueur d'une sous-séquence S_i pour i compris entre 1 et N est inférieure à T.

Notamment, selon un mode de réalisation où L n'est pas un multiple de T i.e. $(N-1) \times T < L < N \times T$, la longueur de la sous séquence S_i est notée $L_{gS\_1}$, et toutes les sous-séquences sauf la dernière sont de taille $L_{gS\_i} = T$.

Dans ce cas, lors de la dernière itération (i.e. la N-ième itération), la sous-séquence S_N possède une taille $L_{gS\_N}$ strictement inférieure à T, car l'algorithme d'entrelacement de longueur L s'arrête à la fin de la séquence d'entrée de longueur L.

En outre, la relation suivante s'applique :

$$L = \sum_{i \in [\![1,N]\!]} L_{gS\_i}$$

**Revendications**

1. Procédé d'entrelacement de données de longueur d'entrelacement L par un dispositif d'entrelacement (10) comprenant un ensemble (24) de $n_{core}$ cœur(s) de processeur, chaque cœur étant associé à une mémoire locale de processeur dont la partie (42) dédiée à la sortie de l'entrelacement est de taille T strictement inférieure à la longueur d'entrelacement L et étant adapté pour mettre en œuvre un algorithme d'entrelacement de longueur L, et $n_{core}$ étant un entier supérieur ou égal à 1, ledit dispositif (10) étant adapté pour mettre en œuvre les étapes suivantes pour réaliser un entrelacement sur une séquence de données à entrelacer :

   - mise en œuvre, N fois, de l'algorithme d'entrelacement de longueur L sur ladite séquence d'entrée, la séquence d'entrée entrelacée étant égale à la réunion de plusieurs sous-séquences consécutives distinctes S_1, ..., S_N et N >1 ;
   - la i<sup>ème</sup> mise en œuvre, i = 1 à N, de l'entrelacement sur ladite séquence d'entrée étant réalisée par un cœur de l'ensemble des $n_{core}$ cœurs, ladite mise en œuvre étant suivie du stockage dans ladite partie de mémoire locale dudit cœur de, parmi les sous-séquences S_1, ..., S_N, seulement la sous-séquence S_i ;
   - puis transfert de chaque sous-séquence S_i dans une mémoire prédéfinie, externe au cœur de processeur ; à l'issue des N transferts, ladite mémoire externe comportant ainsi la séquence d'entrée entrelacée.

2. Procédé d'entrelacement de données selon la revendication 1, selon lequel $n_{core} = N$, et la i<sup>ème</sup> mise en œuvre, i = 1 à N, de l'entrelacement est réalisée

par le i<sup>ème</sup> cœur de processeur, i = 1 à N.

3. Procédé d'entrelacement de données selon la revendication 1, selon lequel $n_{core} < N$ et au moins un même cœur parmi les $n_{core}$ cœurs effectue successivement :

   - la i<sup>ème</sup> mise en œuvre, i compris entre 1 et N-1, de l'entrelacement sur au moins une partie de ladite séquence d'entrée suivie du stockage dans la mémoire locale (42) dudit cœur de seulement la sous-séquence S_i, puis du transfert de la sous-séquence S_i dans la mémoire externe prédéfinie ;
   - la j<sup>ème</sup> mise en œuvre, j compris entre 2 et N et strictement supérieur à i, de l'entrelacement sur au moins une partie de ladite séquence d'entrée suivie du stockage dans la mémoire locale (42) dudit cœur de seulement la sous-séquence S_j, puis du transfert de la sous-séquence S_j dans la mémoire externe prédéfinie.

4. Procédé d'entrelacement de données selon l'une quelconque des revendications précédentes, selon lequel l'indice des bits d'entrée qui sont dans la sous-séquence S_i est précalculé, ainsi que leurs positions respectives associées dans la sous-séquence S_i, et **la** i<sup>ème</sup> mise en œuvre, i = 1 à N, de l'entrelacement sur au moins une partie de ladite séquence d'entrée réalisée par un cœur est effectuée en fonction de l'indice précalculé des bits d'entrée dans la sous-séquence S_i et leurs positions respectives associées dans la sous-séquence S_i.

5. Programme d'ordinateur, destiné à être stocké dans la mémoire, d'un dispositif d'entrelacement (10) comprenant un DSP (24) comportant un ensemble de $n_{core}$ cœur(s) de processeur, chaque cœur étant associé à une mémoire locale de processeur dont la partie (42) dédiée à la sortie de l'entrelacement est de taille T strictement inférieure à la longueur d'entrelacement L et étant adapté pour mettre en œuvre un algorithme d'entrelacement de longueur L, et $n_{core}$ étant un entier supérieur ou égale à 1, ledit dispositif d'entrelacement (10) comprenant un microcalculateur, ledit programme d'ordinateur comprenant des instructions qui, lorsqu'elles sont exécutées sur le microcalculateur, mettent en œuvre les étapes d'un procédé selon l'une des revendications précédentes.

6. Dispositif d'entrelacement (10) comprenant un ensemble (24) de $n_{core}$ cœur(s) de processeur, chaque cœur étant associé à une mémoire locale de processeur dont la partie (42) dédiée à la sortie de l'entrelacement est de taille T strictement inférieure à la longueur d'entrelacement L, ledit dispositif d'entrelacement étant adapté pour mettre en œuvre un algorithme d'entrelacement de longueur L, et $n_{core}$ étant un entier supérieur ou égal à 1, ledit dispositif étant adapté pour mettre en œuvre N fois l'algorithme d'entrelacement de longueur L sur au moins une partie respective d'une séquence d'entrée de données à entrelacer, la séquence d'entrée entrelacée étant égale à la réunion de plusieurs sous-séquences consécutives distinctes S_1, ..., S_N et N > 1 ;

dans lequel la $i^{ème}$ mise en œuvre, i = 1 à N, de l'entrelacement sur au moins une partie de ladite séquence d'entrée est réalisée par un cœur de l'ensemble des $n_{core}$ cœurs, ledit dispositif étant adapté pour, à la suite de ladite mise en œuvre, stocker dans ladite partie de mémoire locale dudit cœur de, parmi les sous-séquences S_1, ..., S_N, seulement la sous-séquence S_i ; ledit dispositif (10) étant adapté pour transférer ensuite chaque sous-séquence S_i dans une mémoire prédéfinie, externe au cœur de processeur de manière à ce qu'à l'issue des N transferts, ladite mémoire externe comportant ainsi la séquence d'entrée entrelacée.

7. Dispositif d'entrelacement de données (10) selon la revendication 6, dans lequel $n_{core}$ = N, et dans lequel la $i^{ème}$ mise en œuvre, i = 1 à N, de l'entrelacement est réalisée par le $i^{ème}$ cœur de processeur, i = 1 à N.

8. Dispositif d'entrelacement de données (10) selon la revendication 6, selon lequel $n_{core}$ < N et au moins un même cœur parmi les $n_{core}$ cœurs est adapté pour effectuer successivement :

   - la $i^{ème}$ mise en œuvre, i compris entre 1 et N-1, de l'entrelacement sur au moins une partie de ladite séquence d'entrée suivie du stockage dans la mémoire locale dudit cœur de seulement la sous-séquence S_i, puis du transfert de la sous-séquence S_i dans la mémoire externe prédéfinie ;
   - la $j^{ème}$ mise en œuvre, j compris entre 2 et N et strictement supérieur à i, de l'entrelacement sur au moins une partie de ladite séquence d'entrée suivie du stockage dans la mémoire locale dudit cœur de seulement la sous-séquence S_j, puis du transfert de la sous-séquence S_j dans la mémoire externe prédéfinie.

9. Dispositif d'entrelacement de données (10) selon l'une quelconque des revendications 6 à 9, dans lequel l'indice des bits d'entrée qui sont dans la sous-séquence S_i est précalculé, ainsi que leurs positions respectives associées dans la sous-séquence S_i, et le dispositif est adapté pour effectuer la $i^{ème}$ mise en œuvre, i = 1 à N, de l'entrelacement sur au moins une partie de ladite séquence d'entrée réalisée par un cœur en fonction de l'indice précalculé des bits d'entrée dans la sous-séquence S_i et leurs positions respectives associées dans la sous-séquence S_i.

FIG.1

**FIG.2**

41

data bits
in (0,1)

M bits

data bits
out (0,1)

42

# FIG.3
# ART ANTERIEUR

1 cœur

DMA

43

44

130 ko

42

# FIG.4

# ART ANTERIEUR

EP 4 765 650 A1

FIG.5

**Ressources**

------  Entrelacement classique  ———  Invention

## FIG.6

## FIG.7

La réalisation pratique sur 4 cœurs

CPU

CPU

CPU

CPU

Le principe d'entrelacement

data bits in (0, 1)

data bits out (0, 1)

Europäisches
Patentamt

European
Patent Office

Office européen
des brevets

**RAPPORT DE RECHERCHE EUROPEENNE**

Numéro de la demande

EP 25 22 4642

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | TURKMANOVIC HARIS ET AL: "Profiling of GNU Radio DVB-S2X transmitter using multi-core CPU and hardware accelerators", 2022 30TH TELECOMMUNICATIONS FORUM (TELFOR), IEEE, 15 novembre 2022 (2022-11-15), pages 1-4, XP034254014, DOI: 10.1109/TELFOR56187.2022.9983695 * alinéa [00I.]; figure 3 * * alinéa [II.B] * * alinéa [III.B] - alinéa [00V.] * ----- | 1-9 | INV. H03M13/27 ADD. H04L1/06 |
| A | US 2008/104478 A1 (OZ JASMIN [US] ET AL) 1 mai 2008 (2008-05-01) * le document en entier * ----- | 1-9 | |
| A | BROADCOM: "A Contention-Free Memory Mapping for ARP interleaved Turbo Codes of Arbitrary Sizes", 3GPP DRAFT; CONTENTION_FREE_MAPPING, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG1, no. Riga, Latvia; 20061108, 8 novembre 2006 (2006-11-08), XP050103487, * le document en entier * ----- | 1-9 | DOMAINES TECHNIQUES RECHERCHES (IPC) H03M H04L |

Le présent rapport a été établi pour toutes les revendications

| Lieu de la recherche | Date d'achèvement de la recherche | Examinateur |
|---|---|---|
| La Haye | 23 avril 2026 | Belardinelli, Carlo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

........................................................................................
& : membre de la même famille, document correspondant

EPO FORM 1503 03.82 (P04C02)

**EP 4 765 650 A1**

## ANNEXE AU RAPPORT DE RECHERCHE EUROPEENNE
## RELATIF A LA DEMANDE DE BREVET EUROPEEN NO.

EP 25 22 4642

23-04-2026

| Document brevet cité au rapport de recherche | Date de publication | Membre(s) de la famille de brevet(s) | Date de publication |
|---|---|---|---|
| US 2008104478 A1 | 01-05-2008 | AUCUN | |

EPO FORM P0460